# EUROPEAN PATENT APPLICATION

(11) **EP 2 407 706 A1**
(43) Date of publication of application: **18.01.2012**
(21) Application number: 10169570.8
(22) Date of filing: 14.07.2010
(51) Int. Cl.: F21K 99/00, H01L 25/075, H01L 33/50

(54) **Warm white light LED lamp with high luminance and high color rendering index and led module**

(71) Applicant: Civilight Shenzhen Semiconductor Lighting Co., Ltd, Shenzhen, Guangdong (CN)
(72) Inventor: Xue, Xinshen, Shenzhen (CN); Wang, Maozhong, Shenzhen (CN); Li, Meihua, Shenzhen (CN)
(74) Representative: MERH-IP Matias Erny Reichl Hoffmann

(57) **Abstract**

A warm white light LED lamp with high luminance and high color rendering index includes a drive circuit, a bracket having a bracket cup, at least one LED wafer which is fixed on the bracket cup and has the wave lengths of 600-650nm, and at least one LED wafer which is fixed on the bracket cup and has the wave lengths of 380-470nm, wherein the LED wafers with the wave lengths of 600-650nm and the LED wafers with the wave lengths of 380-470nm are connected with the drive circuit by electrical wires, the LED wafers with the wave lengths of 380-470nm are coated with fluorescent gel and transparent silica gel, and the LED wafers with the wave lengths of 600-650nm are coated with the transparent silica gel. The present invention further provides a warm white light LED module. The present invention can effectively improve the lighting effect of the LED lamp and the LED module, and the lighting effect of the LED lamp is at least improved by 25%. The warm white light LED lamp and LED module in the present invention have low cost and long service life.

## Description

### TECHNICAL FIELD

The present invention relates to the field of semiconductor illumination, and more particularly, to a warm white light LED lamp with high luminance and color rendering index and an LED module.

### BACKGROUND

Because the semiconductor illumination lamp has the characteristics of environmental protection, super long service life, high efficiency and energy saving, severe environment resistance, simple structure, small volume, light weight, fast response, low work voltage and good security, the semiconductor illumination lamp is regarded as the fourth generation of an illumination electric light source after a filament lamp, a fluorescent lamp and a power saving lamp, or as a green light source in the 21 st century.

Currently, the warm white light which is suitable for illumination on the market is mainly made from LED wafers with the wavelengths of 380-470nm and red fluorescent powder, wherein fluorescent powder are disposed in a center of a bracket cup of the LED. The use level of the fluorescent powder is hardly to be exactly controlled in the prior art, thereby wasting large amount of the fluorescent powder, increasing the product cost, and hardly controlling the consistency in batch production.

Limited by the production process of the fluorescent powder, the luminous flux of the red fluorescent powder is very low, so that the lighting effect of the warm white light is very low, and the color rendering index is approximately only from 70 to 80, thus, it is hard to meet the requirement of lighting products.

### SUMMARY

The technical problem which is needed to be solved by the present patent application is to provide a warm white light LED lamp with high luminance and high color rendering index, and an LED module, thereby solving the problems of a traditional LED lamp and a LED module with high cost and low color rendering index.

One technical scheme for solving the technical problem of the present patent application is as follows: the warm white light LED lamp with high luminance and high color rendering index includes a drive circuit, a bracket having a bracket cup, at least one LED wafer which is fixed on the bracket cup and has the wave lengths of 600-650nm, and/or at least one LED wafer which is fixed on the bracket cup and has the wave lengths of 380-470nm, wherein the LED wafers with the wave lengths of 600-650nm and the LED wafers with the wave lengths of 380-470nm are connected with the drive circuit by electrical wires, the LED wafers with the wave lengths of 380-470nm are coated with fluorescent gel and transparent silica gel, and/or the LED wafers with the wave lengths of 600-650nm are coated with the transparent silica gel.

Preferably, the LED wafers with the wave lengths of 380-470nm are firstly coated with the fluorescent gel and then coated with the transparent silica gel or firstly coated with the transparent silica gel and then coated with the fluorescent gel.

Preferably, the LED wafers with the wave lengths of 600-650nm are only coated with a layer of transparent silica gel or firstly coated with the transparent silica gel and then coated with the fluorescent gel or firstly coated with the fluorescent gel and then coated with the transparent silica gel.

Preferably, the LED wafers with the wave lengths of 380-470nm and the LED wafers with the wave lengths of 600-650nm are arranged in the bracket cup at intervals, or the LED wafers with the wave lengths of 380-470nm are arranged at a middle of the bracket cup, and the LED wafers with the wave lengths of 600-650nm are arranged around the LED wafers with the wave lengths of 380-470nm.

Preferably, the bracket with the bracket cup is replaced with a plane bracket.

Preferably, the fluorescent gel is mixture of the transparent silica gel and the fluorescent powder.

Preferably, the fluorescent powder is yellow powder, orange powder, red powder, green powder or RGB powder.

The other technical scheme for solving the technical problem of the present patent application is as follows: the warm white light LED module with high luminance and high color rendering index includes a drive circuit, a circuit board and a plurality of LEDs fixed on the circuit board, wherein the LEDs are packed by LED wafers with the wave lengths of 600-650nm or LED wafers with the wave lengths of 380-470nm, the red light LEDs which are packed by the LED wafers with the wave lengths of 600-650nm and the LEDs which are packed by the LED wafers with the wave lengths of 380-470nm are evenly distributed on the circuit board according to a certain arrangement mode, and the pins of the LEDs or internal chips are connected with each other via conducting wires.

Preferably, the color coordinates X of white light LEDs which are packed by the LED wafers with the wave lengths of 380-470nm are between 0.36 and 0.41, the color coordinates Y are between 0.41 and 0.46, and the color temperature is between 3500K and 5000K.

Compared with the prior art, the warm white light LED lamp with high luminance and high color rendering index, and the LED module have the following advantages: 1. the present patent application can effectively improve the lighting effect of the LED lamp and the LED module, and the lighting effect of the LED lamp can reach more than 90Lm/W under the condition that the color rendering index be larger than 90 and is at least improved by 25% compared with the lighting effect of the conventional LED lamp and the conventional LED module; 2. the present patent application can be used for producing middle or large power LEDs which are more than 0.1 W. The LED lamp and the LED module in accordance with the present patent application can effectively improve the reliability and the consistency of the product, and can be produced in bulk with machine equipment, to thereby greatly improve the production efficiency, and reduce the product cost; 3. the present patent application can effectively control the use level of the fluorescent gel, thereby not only being capable of increasing the lighting effect of the product, but also being capable of effectively saving cost; and 4. the LED wafers is separated from the fluorescent gel according to different gel dispensing modes, thereby improving the lighting effect and the color rendering index of the LEDs, reducing the luminance attenuation after lighting the LEDs, and prolonging the service life of the LEDs.

### BRIEF DESCRIPTION OF THE DRAWINGS

Other objects, advantages and novel features of the present invention will become more apparent from the following detailed description when taken in conjunction with the accompanying drawings, in which:

FIG 1 is a cross sectional structure view of the first embodiment of the warm white light LED lamp with high luminance and high color rendering index;

FIG. 2 is a cross sectional structure view of the second embodiment of the warm white light LED lamp with high luminance and high color rendering index;

FIG. 3 is a cross sectional structure view of the third embodiment of the warm white light LED lamp with high luminance and high color rendering index;

FIG. 4 is a cross sectional structure view of the fourth embodiment of the warm white light LED lamp with high luminance and high color rendering index;

FIG. 5 is a top view of the first embodiment of the warm white light LED module with high luminance and high color rendering index; and

FIG. 6 is a top view of the second embodiment of the warm white light LED module with high luminance and high color rendering index.

### DETAILED DESCRIPTION OF THE PREFERRED EMBODIMENTS

Objects, advantages and embodiments of the present invention will be explained below in detail with reference to the accompanying drawings. However, it is to be appreciated that the following description of the embodiment(s) is merely exemplary in nature and is no way intended to limit the invention, its application, or uses.

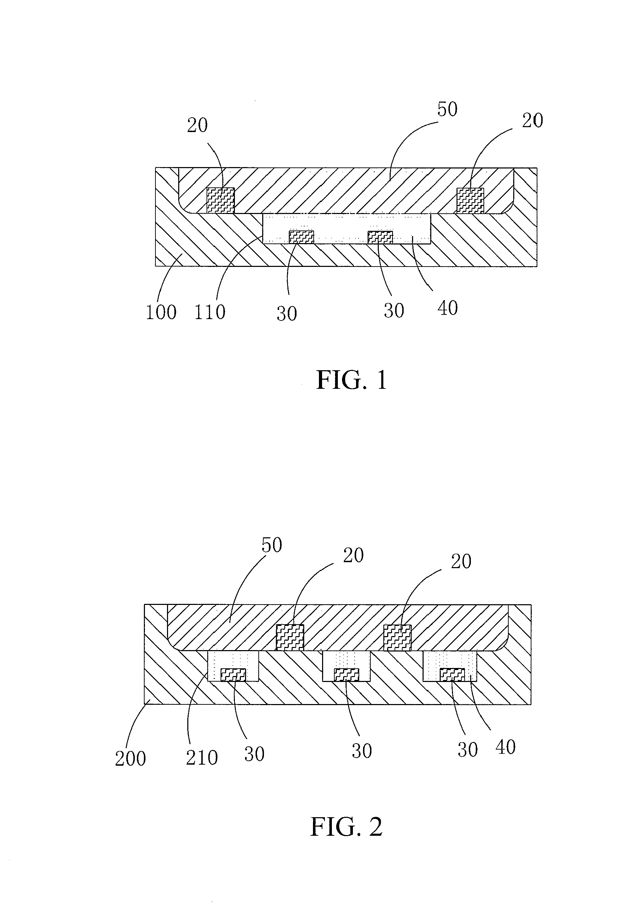

Referring to the FIG. 1, in the first embodiment, the warm white light LED lamp with high luminance and high color rendering index, the power of the light LED lamp is more than 0.1 W. The warm white light LED lamp includes a drive circuit (not shown), a bracket 100 having a bracket cup 110, LED wafers and fluorescent gel 40 coated on the LED wafers. The bracket cup 110 is shaped like an English character "'T". The two LED wafers 20 (such as red light LED or orange light LED) with the wave lengths of 600-650nm are fixedly connected with the bracket 100 and are arranged on the upper portion of the bracket cup 110, and the two LED wafers 30 (such as blue light LED) with the wave lengths of 380-470nm are arranged at the middle of the bracket cup 110 and located below the LED wafers 20 with the wave lengths of 600-650nm. The LED wafers 20 with the wave lengths of 600-650nm and the LED wafers 30 with the wave lengths of 380-470nm are connected with the drive circuit by electrode wires (not labelled), fluorescent gel 40 is only coated on the LED wafers 30 with the wave lengths of 380-470nm, and transparent silica gel 50 is only coated on the LED wafers 20 with the wave lengths of 600-650nm or on the whole bracket 10. The transparent silica gel 50 has higher refractive index to improve the lighting effect of the LEDs. The fluorescent gel 40 is mixture of the transparent silica gel 50 and the fluorescent powder, and the fluorescent powder is yellow powder, orange powder, red powder, green powder or RGB powder.

Referring to the FIG.2, in the second embodiment, the warm white light LED lamp with high luminance and high color rendering index, the power of the LED lamp is more than 0.1W. The warm white light LED lamp includes a drive circuit (not shown), a bracket 200 with a bracket cup 210, LED wafers and the fluorescent gel 40 coated on the LED wafers. The middle of the bracket cup 210 of the bracket 110 is provided with a plurality of grooves at intervals. The two LED wafers 20 with the wave lengths of 600-650nm are fixedly connected with the bracket 200 and arranged at the upper portion of the bracket cup 210, and the two LED wafers 30 with the wave lengths of 380-470nm are located in the corresponding grooves and are arranged with the two LED wafers 20 with the wave lengths of 600-650nm at intervals. The LED wafers 20 with the wave lengths of 600-650nm and the LED wafers 30 with the wave lengths of 380-470nm are connected with the drive circuit by electrical wires (not labelled), the fluorescent gel 40 is only coated on the LED wafers 30 with the wave lengths of 380-470nm, and the transparent silica gel 50 is only coated on the LED wafers 20 with the wave lengths of 600-650nm or on the whole bracket 200. The transparent silica gel 50 has higher refractive index to improve the lighting effect of the LEDs.

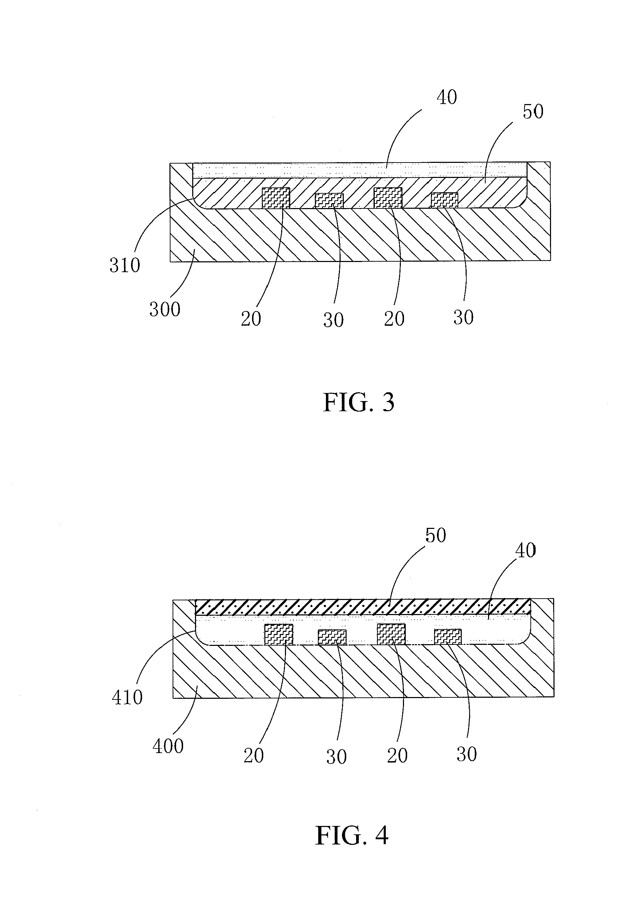

Referring to the FIG.3, in the third embodiment, the warm white light LED lamp with high luminance and high color rendering index, the warm white light LED lamp includes a drive circuit, a bracket 300 having a bracket cup 310, LED wafers and the fluorescent gel 50 coated on the LED wafers. The bracket cup 310 of the bracket 300 is internally provided with two LED wafers 20 with the wave lengths of 600-650nm and two LED wafers 30 with the wave lengths of 380-470nm, which are alternately arranged. The LED wafers 20 with the wave lengths of 600-650nm and the LED wafers 30 with the wave lengths of 380-470nm are connected with the drive circuit by electrical wires (not labelled), and the LED wafers 20 with the wave lengths of 600-650nm and the LED wafers 30 with the wave lengths of 380-470nm are firstly coated with a layer of the transparent silica gel 50 and then coated with a layer of the fluorescent glue 40. In the third embodiment, the fluorescent glue 40 is separated from the two wafers via the transparent silica gel 50, thereby reducing the influence of the heat energy generated by the LED wafers to the fluorescent glue and effectively prolonging the service life of the LEDs.

Referring to the FIG.4, in the fourth embodiment, the warm white light LED lamp with high luminance and high color rendering index, the LED lamp includes a drive circuit, a bracket 400 having a bracket cup 410, LED wafers and the fluorescent gel 40 coated on the LED wafers. The bracket cup 4310 of the bracket 400 is internally provided with two LED wafers 20 with the wave lengths of 600-650nm and two LED wafers 30 with the wave lengths of 380-470nm, which are alternately arranged. The LED wafers 20 with the wave lengths of 600-650nm and the LED wafers 30 with the wave lengths of 380-470nm are connected with the drive circuit by electrical wires (not labelled), and the LED wafers 20 with the wave lengths of 600-650nm and the LED wafers 30 with the wave lengths of 380-470nm are firstly coated with a layer of the transparent silica gel 40 and then coated with a layer of the fluorescent glue 50. In the embodiment, the LED wafers 20 with the wave lengths of 600-650nm and the LED wafers 30 with the wave lengths of 380-470nm are jointly coated with a layer of the transparent silica gel 40 and then coated with a layer of the fluorescent glue 50, thereby improving the lighting effect and the color rendering index of the product, improving evenness of facula, and having good light emission effect.

In the above-mentioned four embodiments, by reasonably allocating the quantitative proportion and the mutual position relationship between the LED wafers with the wave lengths of 600-650nm and the LED wafers 30 with the wave lengths of 380-470nm, the beams emitted from the red light wafer or the orange light wafer are mixed together, therefore, the lighting effect can reach more than 90Lm/W, and the color rendering index also is more than 90. Furthermore, according to the luminance of the red light wafer and actual demand, the fluorescent gel and the transparent gel are coated on the LED wafers to meet the requirements of various different color temperatures. Moreover, in the above-mentioned four embodiments, the bracket having the bracket cup also can be replaced by a plane bracket.

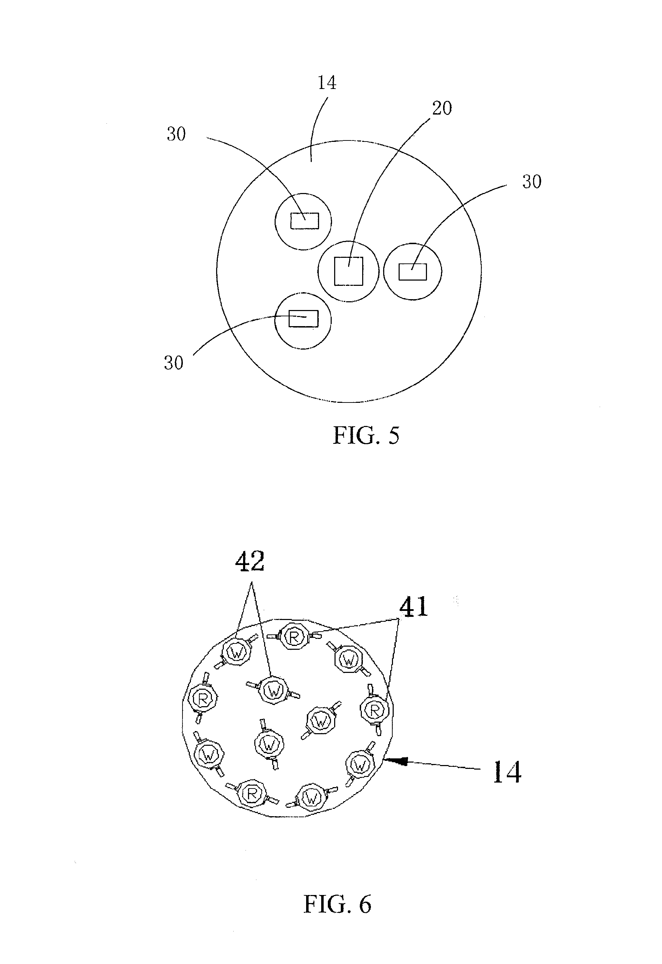

Referring to the Fig. 5, in the first embodiment of a warm white light LED module with high luminance and high color rendering index, the LED module includes a drive circuit, a circuit board 14, red LEDs which are packed by the LED wafers with the wave lengths of 600-650 nm on the circuit board 14, and white LEDs which are packed by the LED wafers with the wave lengths of 380-470nm. The inner chips are connected each another via conducting wires.

Referring to the FIG.6, in the second embodiment of a warm white light LED module with high luminance and high color rendering index, the LED module includes a drive circuit, a circuit board 14, red LEDs which are packed by the LED wafers with the wave lengths of 600-650 nm on the circuit board 14, and white LEDs which are packed by the LED wafers with the wave lengths of 380-470nm. The pins of the LEDs are connected each another via the conducting wires. Three white light LEDs 42 are evenly arranged at the center of the circuit board 14, five white light LEDs 42 and four red light or orange light LEDs 41 are evenly arranged at the circular periphery of the three white light LEDs 42. In the warm white light LED module, by adjusting the arrangement numbers of the red light or the orange light LEDs 41 and the white light LEDs 42, different luminance and different color temperatures can be obtained. For example, the color temperature can reach 2500K through arranging the two red light or orange light LEDs 41 and the four white light LEDs 42, and the color temperature can reach 3000K through arranging one red light or orange light LED 41 and the four white light LEDs 42. The rest can be done in the same manner, and different luminous effects can be obtained by means of arrangement of the red light or orange light LED 41 and the white light LEDs 42.

The warm white light LED lamp with high luminance and high color rendering index and the LED module have the following advantages: 1. the present patent application can effectively improve the lighting effect of the LED lamp and the LED module, and the lighting effect of the LED lamp can reach more than 90Lm/W under the condition that the color rendering index be larger than 90 and is at least improved by 25% compared with the lighting effect of the conventional LED lamp and the conventional LED module; 2. the present patent application can be used for producing middle on large power LEDs which are more than 0.1 W. The LED lamp and the LED module in accordance with the present patent application can effectively improve the reliability and the consistency of the product, and can be produced in bulk with machine equipment, to thereby greatly improve the production efficiency, and reduce the product cost; 3. the present patent application can effectively control the use level of the fluorescent gel, thereby not only being capable of increasing the lighting effect of the product, but also being capable of effectively saving cost; and 4. the LED wafers is separated from the fluorescent gel according to different gel dispensing modes, thereby improving the lighting effect and the color rendering index of the LEDs, reducing the luminance attenuation after lighting the LEDs, and prolonging the service life of the LEDs.

The present invention may be embodied in other forms without departing from the spirit or novel characteristics thereof. The embodiments disclosed in this application are to be considered in all respects as illustrative and not limitative. The scope of the invention is indicated by the appended claims rather than by the foregoing description; and all changes which come within the meaning and range of equivalency of the claims are intended to be embraced therein.

Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description.

## Claims

1. A warm white light LED lamp with high luminance and high color rendering index comprising:
a drive circuit ;
a bracket having a bracket cup ;
at least one LED wafer fixed on the bracket cup and having the wave lengths of 600-650nm; and
at least one LED wafer fixed on the bracket cup and having the wave lengths of 380-470nm, wherein the LED wafers with the wave lengths of 600-650nm and the LED wafers with the wave lengths of 380-470nm are connected with the drive circuit by electrical wires, the LED wafers with the wave lengths of 380-470nm are coated with fluorescent gel and transparent silica gel, and the LED wafers with the wave lengths of 600-650nm are coated with the transparent silica gel.

2. The warm white light LED lamp as claimed in claim 1, wherein the LED wafers with the wave lengths of 380-470nm are firstly coated with the fluorescent gel and then coated with the transparent silica gel or firstly coated with the transparent silica gel and then coated with the fluorescent gel.

3. The warm white light LED lamp as claimed in claim 1 or claim 2, wherein the LED wafers with the wave lengths of 600-650nm are only coated with a layer of transparent silica gel or firstly coated with the transparent silica gel and then coated with the fluorescent gel or firstly coated with the fluorescent gel and then coated with the transparent silica gel.

4. The warm white light LED lamp as claimed in at least one of claims 1 to 3, wherein the LED wafers with the wave lengths of 380-470nm and the LED wafers with the wave lengths of 600-650nm are arranged in the bracket cup at intervals, or the LED wafers with the wave lengths of 380-470nm are arranged at a middle of the bracket cup, and the LED wafers with the wave lengths of 600-650nm are arranged around the LED wafers with the wave lengths of 380-470nm.

5. The warm white light LED lamp as claimed in at least one of claims 1 to 4, wherein the bracket having the bracket cup is replaced with a plane bracket.

6. The warm white light LED lamp as claimed in at least one of claims 1 to 5, wherein the fluorescent gel is mixture of the transparent silica gel and the fluorescent powder.

7. The warm white light LED lamp as claimed in claim 6, wherein the fluorescent powder is yellow powder, orange powder, red powder, green powder or RGB powder.

8. A the warm white light LED module with high luminance and high color rendering index comprising:
a drive circuit;
a circuit board; and
a plurality of LEDs fixed on the circuit board, wherein the LEDs are packed by LED wafers with the wave lengths of 600-650nm or LED wafers with the wave lengths of 380-470nm, red light LEDs which are packed by the LED wafers with the wave lengths of 600-650nm and the LEDs which are packed by the LED wafers with the wave lengths of 380-470nm are evenly distributed on the circuit board according to a certain arrangement mode, and pins of the LEDs or internal chips are connected with each another via conducting wires.

9. The warm white light LED module as claimed in claim 8, wherein the color coordinates X of white light LEDs which are packed by the LED wafers with the wave lengths of 380-470nm are between 0.36 and 0.41, the color coordinates Y are between 0.41 and 0.46, and the color temperature is between 3500K and 5000K.
